# FASCICULE DE BREVET EUROPEEN

(11) **EP 1 852 707 B1**
(45) Date de publication et mention de la délivrance du brevet: **11.09.2013**
(21) Numéro de dépôt: 07107309.2
(22) Date de dépôt: 02.05.2007
(51) Int. Cl.: G01R 33/04

(54) **Micromagnetometre de type fluxgate a bobinage d'excitation ameliore**
Fluxgate-Mikromagnetometer mit verbesserter Anregungswicklung
Fluxgate-type micromagnetometer with improved field coil

(30) Priorité: 04.05.2006 FR 0651615
(43) Date de publication de la demande: 07.11.2007
(73) Titulaire: Commissariat à l'Énergie Atomique et aux Énergies Alternatives, 75015 Paris (FR)
(72) Inventeur: Delevoye, Elisabeth, 38000, Grenoble (FR); Jeandey, Christian, 38120 Saint-Egreve (FR)
(74) Mandataire: Ahner, Philippe

(56) Documents cités:
- EP-A2- 1 345 036
- EP-A2- 1 484 618
- GOTTFRIED-GOTTFRIED R ET AL: "A MINIATURIZED MANGETIC-FIELD SENSOR SYSTEM CONSISTING OF A PLANAR FLUXGATE SENSOR AND A CMOS READOUT CIRCUITRY" SENSORS AND ACTUATORS A, ELSEVIER SEQUOIA S.A., LAUSANNE, CH, vol. A54, no. 1/3, juin 1996 (1996-06), pages 443-446, XP000637151 ISSN: 0924-4247
- KAWAHITO S ET AL: "High-resolution micro-fluxgate sensing elements using closely coupled coil structures" SENSORS AND ACTUATORS A, ELSEVIER SEQUOIA S.A., LAUSANNE, CH, vol. 54, no. 1-3, juin 1996 (1996-06), pages 612-617, XP004077934 ISSN: 0924-4247

## Description

### DOMAINE TECHNIQUE

La présente invention se rapporte au domaine des microtechnologies et des magnétomètres ou capteurs magnétiques, et met en oeuvre un dispositif magnétomètre de type fluxgate réalisé en couches minces, doté d'un circuit magnétique d'au moins un bobinage d'excitation, d'au moins un bobinage de détection, le bobinage d'excitation ayant en particulier un agencement et une structure améliorés.

Le dispositif suivant l'invention, apporte des améliorations notamment en termes d'encombrement du magnétomètre, de précision des mesures, en particulier en ce qui concerne la réduction des décalages ou « offsets » (selon la terminologie anglo-saxonne) de mesures, la réjection du mode commun.

### ART ANTÉRIEUR

Les magnétomètres à « fluxgate » trouvent emploi dans des mesures de champs magnétiques qui peuvent être faibles ou même très faibles, par exemple de l'ordre du microtesla avec une résolution de l'ordre du nanotesla ou même de l'ordre de plusieurs picoteslas, suivant les dimensions du magnétomètre. Un magnétomètre de type « fluxgate », est classiquement doté : d'un capteur, de moyens d'excitation ou d'un circuit d'excitation apte à délivrer un signal périodique d'excitation au capteur, et de moyens de détection ou d'un circuit de détection en sortie du capteur (voir par exemple EP-A-1 345 036). Le capteur comprend généralement un circuit magnétique formé d'un noyau magnétique, ainsi qu'un ou plusieurs bobinages chargés de l'excitation du circuit magnétique et un ou plusieurs bobinages « récepteurs » ou de « détection » chargés de la mesure. Ces éléments fonctionnent en collaboration. La détection peut être par exemple réalisée à la fréquence double du signal d'excitation, comme dans les magnétomètres de type fluxgate de type dit « Vacquier » ou de type dit « Foster ».

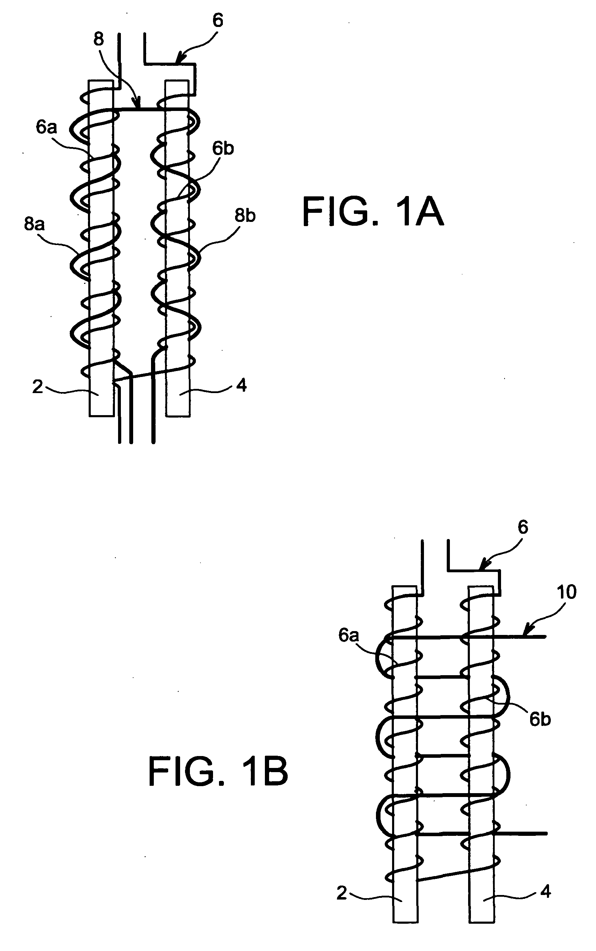

Sur la figure 1A, un premier exemple de magnétomètre fluxgate de type « Vacquier », et en particulier le circuit magnétique de ce magnétomètre associé à des bobinages d'excitation et de détection, est donné. Le circuit magnétique est ouvert et comprend un premier noyau 2, ainsi qu'un deuxième noyau 4 parallèle au premier noyau 2. Le bobinage d'excitation 6 est formé d'une première succession de spires 6a enroulées autour du premier noyau 2, reliée en série à une deuxième succession de spires 6b enroulées autour du deuxième noyau 4. Le bobinage de détection 8 est quant à lui formé d'une succession de spires 8a enroulées autour du premier noyau 2, reliée en série à une autre succession de spires 8b enroulées autour du deuxième noyau 4. Le bobinage d'excitation 6 et le bobinage de détection 8 peuvent être entrelacés.

Sur la figure 1B, un deuxième exemple de circuit magnétique d'un magnétomètre de type fluxgate de type « Foster » associé à des bobinages d'excitation et de détection est illustré. Dans ce dispositif le circuit magnétique est également formé d'un premier noyau 2, et d'un deuxième noyau 4 parallèle au premier noyau 2. Un bobinage d'excitation 6 ayant un agencement semblable à celui du dispositif de type « Vacquier » précédemment décrit, est prévu. Le bobinage de détection 10 est quant lui à formé d'une succession de spires enroulées autour du premier noyau 2 et du deuxième noyau 4, les spires passant alternativement dans un plan situé au dessus des deux noyaux 2 et 4 puis dans un autre plan situé au dessous des deux noyaux 2 et 4. Le bobinage d'excitation 6 et le bobinage de détection 8 peuvent être également entrelacés.

Dans l'un ou l'autre des magnétomètres de type fluxgate précédemment décrits, le magnétomètre mesure un champ extérieur H₀ auquel il est soumis par une méthode de sommation des signaux provenant des noyaux 2 et 4, qui sont excités par un champ magnétique H_{exc} produit par le bobinage d'excitation 6. L'agencement des bobinages est tel que si un champ par exemple égal à H_{exc}+ H₀ est produit au niveau du premier noyau 2, un champ -H_{exc} + H₀ est produit au niveau du deuxième noyau 4. Le signal recueilli en sortie du bobinage de détection comporte généralement un décalage parasite ou offset (selon la terminologie anglo-saxonne) qui s'avère particulièrement important lorsque l'ordre de grandeur du champ magnétique à mesurer est faible.

Les magnétomètres peuvent s'appliquer au domaine de la microtechnologie et être incorporés par exemple dans des circuits intégrés. Ils sont alors fabriqués grâce à des techniques de réalisation en couches minces. Les magnétomètres formés en couches minces peuvent atteindre des tailles d'un ordre inférieur au millimètre, avec des couches minces qui peuvent être de l'ordre du micromètre ou inférieures.

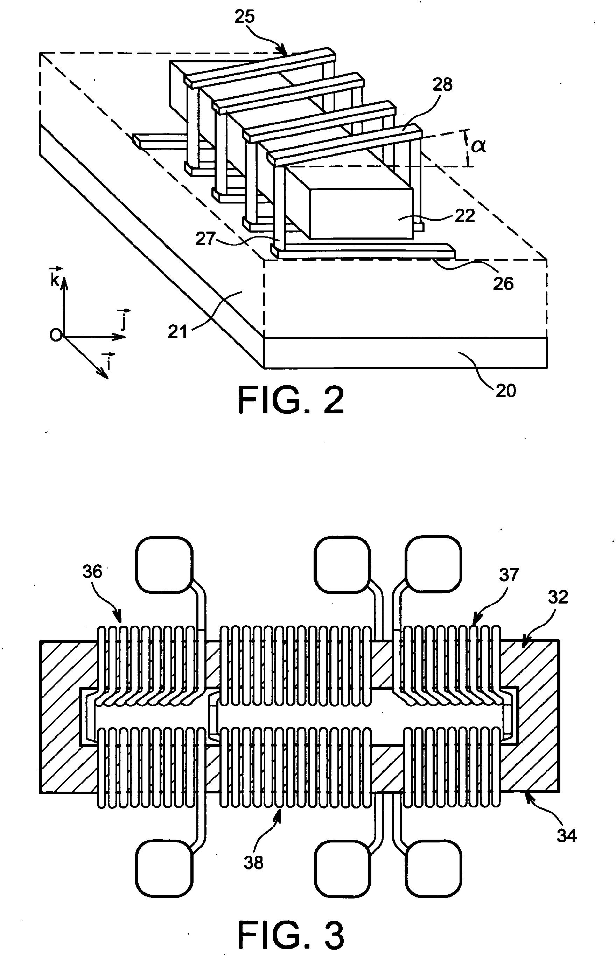

Un bobinage d'excitation 25, enroulé autour d'un noyau magnétique 22 d'un circuit magnétique d'un magnétomètre, est illustré sur la figure 2. Le noyau magnétique 22 s'étend dans une direction principale donnée (parallèle à un vecteur *̅i̅*̅ d'un repère orthogonal [O;*̅i̅*̅;*̅j̅*̅;*̅k̅*̅] défini sur la figure 2) et repose sur un support, qui peut être sous forme d'un substrat 20 recouvert d'un empilement 21 de couches minces. Le bobinage d'excitation 25 est formé d'une première pluralité de zones conductrices 26 formées dans un plan situé entre le substrat 20 et le noyau 22 et une deuxième pluralité de zones conductrices 28 situées au dessus du noyau magnétique 22, chaque zone conductrice de la deuxième pluralité de zone conductrice 28 étant reliée à un zone conductrice de la première pluralité de zones conductrices 26 par l'intermédiaire d'une interconnexion verticale 27 communément appelée « via ». Dans ce dispositif, l'agencement du bobinage d'excitation est tel que les zones conductrices de la deuxième pluralité de zones conductrices 28 réalisent un angle *α* non-nul avec un plan orthogonal à la direction principale du noyau 22. Par ailleurs le bobinage d'excitation 25 n'est pas entrelacé avec un bobinage de détection (non représenté).

Les documents : « Integrated microfluxgate study and characterization », Proc. Eurosensors XI, vol. 1, 199, p.267-270, Léger et al., et «Microfluxgate Performance Improvement in Microtechnology», Joisten and al., Novembre 2005, IEEE transaction on magnetics, vol.41 issue 11 p4356-4358, présentent un magnétomètre de type fluxgate comprenant : deux noyaux 32, 34, reliés entre eux et formant un circuit magnétique fermé, des bobinages d'excitation 36, 37, enroulés autour des noyaux 32, 34, du circuit magnétique de part et d'autre d'un bobinage de détection 38 (figure 3). Ce dispositif diffère de celui décrit précédemment en liaison avec la figure 3, notamment en ce que les bobinages d'excitation comportent des spires situées respectivement dans un plan orthogonal aux noyaux 32, 34, ce qui peut permettre, d'obtenir une amplitude du champ magnétique induit plus importante. Cependant dans un tel dispositif, comme dans celui précédemment décrit en liaison avec la figure 3, le bobinage d'excitation et de détection sont disposés autour du noyau dans des zones distinctes, ce qui pose un problème d'encombrement.

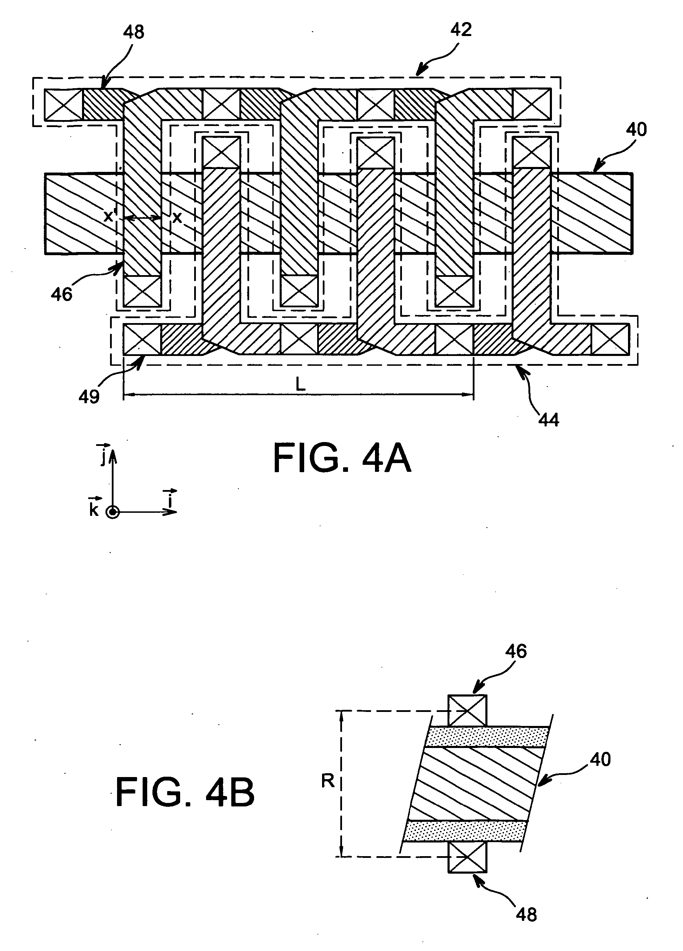

Un autre exemple de réalisation en couches minces d'un magnétomètre de type fluxgate suivant l'art antérieur, et en particulier un dispositif microtechnologique comprenant le circuit magnétique du magnétomètre associé à des bobinages d'excitation et de détection, est illustré en vue de dessus sur la figure 4A et selon une vue en coupe X'X sur la figure 4B (la coupe X'X étant indiquée sur la figure 4A par un axe parallèle à un vecteur *̅i̅*̅ d'un repère orthogonal [O;*̅i̅*̅;*̅j̅*̅;*̅k̅*̅]). Ce dispositif comprend un bobinage d'excitation 42 et un bobinage de détection 44 entrelacés et agencés autour d'un noyau magnétique 40. Le bobinage d'excitation 42 et le bobinage de détection 44 comportent notamment une première série de zones conductrices 46 parallèles situées au dessus du noyau magnétique 40 ainsi qu'une deuxième série de zones conductrices 48 parallèles situées au dessous du noyau magnétique 6. Pour chacun des bobinages d'excitation 42 et de détection 44, les zones conductrices 46 de la première série sont situées en regard des zones conductrices 44 de la deuxième série. Les zones conductrices 46 de la première série et les zones conductrices 44 de la deuxième série sont également reliées par l'intermédiaire d'interconnexions verticales 49 communément appelés « via » (selon la terminologie anglo-saxonne). Les bobinages d'excitation 42 et de détection 44 forment respectivement un solénoïde.

Il se pose le problème de trouver un nouveau dispositif de micromagnétomètre de type fluxgate, qui présente des améliorations en termes d'encombrement et de performances de mesure.

### EXPOSÉ DE L'INVENTION

L'invention a pour but de présenter un dispositif de micro-magnétomètre ou magnétomètre réalisée en couche minces comprenant un circuit magnétique formé de plusieurs noyaux et au moins un bobinage d'excitation ayant une structure et un agencement vis-à-vis des noyaux améliorés. Le bobinage d'excitation a une structure différente de celle d'un solénoïde classique. L'agencement du bobinage d'excitation permet d'éviter les effets de ligne distribuée ou de déphasage que l'on retrouve avec les agencements classiques de bobinage d'excitation.

Le bobinage d'excitation peut être formé d'une succession de contours conducteurs fermés entourant les noyaux, les contours conducteurs étant reliés en série.

Par contour conducteur, on entend une partie conductrice de l'électricité formant une bague autour des noyaux.

Le nombre de noyaux d'un micro-magnétomètre ou magnétomètre suivant l'invention n'est pas limité à deux. Le bobinage d'excitation peut être formé d'une succession de contours conducteurs fermés entourant plus de deux noyaux, les contours conducteurs étant reliés entre eux.

L'invention permet de mettre en oeuvre une synchronisation spatiale des phénomènes magnétiques induits par les noyaux.

L'invention concerne tout d'abord un micromagnétomètre de type fluxgate réalisé en couches minces, comprenant :
- un support ayant un plan principal donné,
- un circuit magnétique doté d'au moins un premier noyau magnétique de direction principale donnée et au moins un deuxième noyau magnétique parallèle au premier noyau,
- au moins un bobinage d'excitation formé d'une succession d'éléments conducteurs reliés en série,
- des moyens pour appliquer un signal d'excitation à ladite série d'éléments conducteurs,
   le bobinage d'excitation comportant : des zones conductrices plates parallèles entre elles s'étendant dans une direction réalisant un angle non-nul avec ladite direction principale donnée et situées respectivement dans un plan parallèle au plan principal du support, une première pluralité de zones conductrices plates étant situées en regard du premier noyau, une deuxième pluralité de zones conductrices plates étant situées en regard du deuxième noyau, au moins plusieurs éléments conducteurs du bobinage d'excitation étant formés respectivement : d'au moins une première zone conductrice plate de ladite deuxième pluralité de zones conductrices reliée à une deuxième zone conductrice plate de ladite première pluralité de zones conductrices plates et située dans un même plan orthogonal au plan principal du support que ladite deuxième zone conductrice plate.

Les éléments conducteurs du bobinage d'excitation sont formés respectivement d'une partie conductrice réalisant un contour fermé entourant les noyaux ou une bague entourant les noyaux, et comprenant ladite première zone conductrice plate et ladite deuxième zone conductrice plate.

Avec un tel agencement d'éléments conducteurs, les effets parasites qu'une éventuelle imperfection géométrique au niveau d'un élément conducteur pourraient induire, ne se transmettent pas aux éléments conducteurs suivants.

Le micromagnétomètre peut également comprendre au moins un bobinage de détection.

Lesdites zones conductrices plates de ladite première pluralité de zones conductrices plates et de ladite deuxième pluralité de zones conductrices plates, peuvent être orientées selon une direction orthogonale à ladite direction principale donnée.

Les éléments conducteurs du bobinage d'excitation peuvent être formés en outre:
- d'un premier lien conducteur relié à ladite partie conductrice et destiné à acheminer un courant en provenance d'un élément conducteur précédent de ladite série d'éléments conducteurs ou des moyens pour appliquer le signal d'excitation,
- d'un deuxième lien conducteur relié à ladite partie conductrice et destiné à transmettre un courant vers un élément conducteur suivant de ladite série d'éléments conducteurs ou aux moyens pour appliquer le signal d'excitation.

Selon cette possibilité de réalisation, ladite première zone conductrice plate et ladite deuxième zone conductrice plate sont situées dans un premier plan parallèle au plan principal du support, ladite deuxième zone conductrice plate étant reliée et alignée avec ladite première zone conductrice plate.

La partie conductrice réalisant un contour conducteur fermé peut comprendre en outre : une troisième zone conductrice plate et une quatrième zone conductrice plate reliée à, et alignée avec, la troisième zone conductrice plate, la troisième zone conductrice plate et la quatrième zone conductrice plate étant connectées respectivement à ladite première zone conductrice plate et à ladite deuxième zone conductrice plate et étant situées dans un deuxième plan, parallèle au plan principal du support et tel que les noyaux sont placés entre ledit premier plan et ledit deuxième plan.

Selon cette possibilité, les troisième zone conductrice plate et quatrième zone conductrice plate peuvent être situées dans un même plan orthogonal au plan principal du support que les dites première zone conductrice plate et deuxième zone conductrice plate.

La partie conductrice réalisant un contour fermé peut être formée d'une première portion conductrice entourant partiellement le premier noyau et d'une deuxième portion conductrice entourant partiellement le deuxième noyau, la première portion conductrice et la deuxième portion conductrice étant identiques.

Le premier lien conducteur et le deuxième lien conducteur peuvent être situés entre les noyaux et orientés dans une direction parallèle à la direction principale donnée, le deuxième lien et le premier lien étant situés respectivement dans un premier plan parallèle au plan principal du support, et dans un deuxième plan, parallèle au plan principal du support et tel que les noyaux sont placés entre le premier plan et le deuxième plan.

Le dispositif suivant l'invention peut comprendre en outre au moins un bobinage de détection enroulé autour des noyaux, et éventuellement agencé de sorte que, le bobinage de détection et le bobinage de d'excitation sont entrelacés.

Selon une mise en oeuvre possible, le bobinage de détection peut être formé d'une succession de spires passant respectivement alternativement, en regard de tous les noyaux dans un premier plan parallèle au plan principal du support et en regard de tous les noyaux dans un deuxième plan parallèle au plan principal du support et tel que les noyaux sont situés entre le premier plan et le deuxième plan.

Selon une variante, le bobinage de détection peut être formé d'une succession de spires conductrices reliées en série, une pluralité de spires du bobinage de détection comportant respectivement :
une pluralité de zones conductrices plates parallèles entre elles, situées respectivement en regard des noyaux du circuit magnétique dans un plan parallèle au plan principal du support et s'étendant respectivement dans une direction réalisant un angle non-nul avec ladite direction principale donnée, les zones conductrices plates du bobinage de détection ayant une largeur l'c supérieure à la largeur lc des zones conductrices plates du bobinage d'excitation.

L'invention concerne également un dispositif comprenant :
- un premier micromagnétomètre de type fluxgate tel que défini plus haut, doté de noyaux orientés selon une première direction principale,
- au moins un deuxième micromagnétomètre de type fluxgate tel que défini plus haut, doté de noyaux orientés selon une deuxième direction principale orthogonale à ladite première direction principale.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- les figures 1A, 1B, illustrent respectivement, un agencement de bobinages de type « Vacquier » dans un magnétomètre de type fluxgate suivant l'art antérieur, et un autre agencement de bobinages de type « Foster » dans un magnétomètre de type fluxgate suivant l'art antérieur,
- la figure 2 illustre un exemple d'agencement d'un bobinage d'excitation dans un micromagnétomètre de type fluxgate suivant l'art antérieur,
- la figure 3 illustre un autre exemple d'agencement d'un bobinage d'excitation dans un micromagnétomètre de type fluxgate suivant l'art antérieur,
- les figures 4A, 4B, illustrent selon une vue de dessus et selon une vue en coupe, un autre exemple d'agencement d'un bobinage d'excitation et d'un bobinage de détection dans un micromagnétomètre de type fluxgate suivant l'art antérieur,
- les figures 5A, 5B, illustrent un exemple de magnétomètre de type fluxgate suivant l'invention, doté d'un bobinage d'excitation et d'un bobinage de détection ayant respectivement une structure et un agencement particuliers,
- la figure 6 illustre un exemple d'agencement et de structure d'un bobinage d'excitation et d'un bobinage de détection dans un micromagnétomètre de type fluxgate suivant l'invention,
- la figure 7 illustre un exemple de micromagnétomètre bi-axe suivant l'invention,
- la figure 8 illustre un schéma électrique équivalent de l'excitation mis en oeuvre à l'aide du micromagnétomètre de la figure 6,
- la figure 9 illustre un schéma électrique équivalent de l'excitation d'un exemple de magnétomètre de type fluxgate suivant l'invention, doté d'un nombre de noyaux supérieur à 2,

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

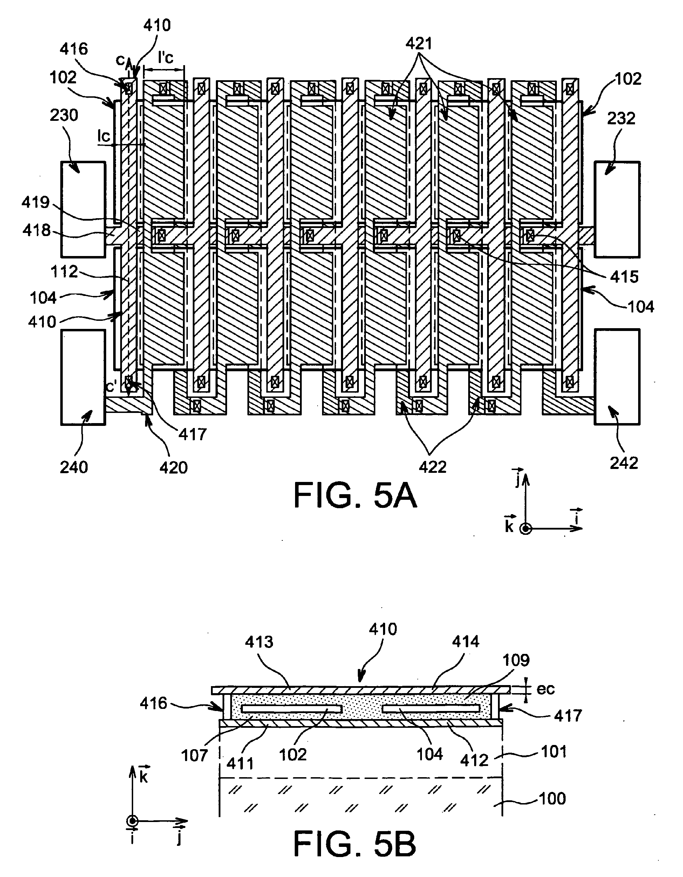

Un exemple de micromagnétomètre de type fluxgate réalisé en couches minces, et en particulier un dispositif comprenant un circuit magnétique associé à un bobinage d'excitation 410 et un bobinage de détection 420, est illustré sur les figures 5A et 5B, le dispositif étant représenté selon une vue de dessus sur la figure 5A, et selon une vue en coupe C'C sur la figure 5B (la coupe C'C étant indiquée sur la figure 5A). Ce dispositif comporte notamment un bobinage d'excitation 410 d'agencement et de structure améliorées. Le bobinage de détection 420 peut également avoir un agencement et une structure améliorées.

Le circuit magnétique est réalisé sur un support, qui peut être sous forme d'un substrat 100, par exemple semi-conducteur, recouvert d'un empilement 101 de couches minces. Le circuit magnétique est formé d'un premier noyau 102 magnétique ayant une direction principale donnée (la direction principale du premier noyau 102 étant définie sur les figures 5A, 5B, par une direction parallèle au vecteur *̅i̅*̅ d'un repère orthogonal [O;*̅i̅*̅;*̅j̅*̅;*̅k̅*̅]) et d'un deuxième noyau 104 magnétique de direction principale parallèle à celle du premier noyau 102.

Dans cet exemple, le premier noyau 102 et le deuxième noyau 104 ne sont pas reliés entre eux et sont situés dans un même plan parallèle au plan principal du support (le plan principal du support étant défini comme un plan, passant par le substrat 100 ou l'empilement 101, et parallèle au plan [O*;i̅;j̅*] du repère orthogonal [O*; i̅ ; j̅ ; k̅* ]).

Le premier noyau 102 magnétique et le deuxième noyau 104 magnétique peuvent être par exemple sous forme de blocs parallélépipédiques à base d'un matériau magnétique, par exemple tel que du FeNi, reposant sur une couche de matériau diélectrique. Les noyaux 102 et 104 ont une longueur respective (mesurée dans une direction parallèle au vecteur *̅i̅*̅ du repère [O; *i̅; j̅* ; *̅k̅*̅ ] ), qui peut être par exemple comprise entre 100 µm et 10000 µm ou de l'ordre de 1000 µm.

La largeur respective des noyaux 102 et 104 (mesurée dans une direction parallèle au vecteur *̅j̅*̅ du repère orthogonal [O;*̅i̅*̅;*̅j̅*̅;*̅k̅*̅]) peut être comprise par exemple entre 10 µm et 1000 µm, ou de l'ordre de 100 µm. Les noyaux 102 et 104 ont une épaisseur respective (mesurée dans une direction parallèle au vecteur *̅k̅*̅ du repère [O;*̅i̅*̅;*̅j̅*̅;*̅k̅*̅]) qui peut être par exemple comprise entre 0,1 µm et 50 µm, ou entre 1 µm et 5 µm.

Le bobinage d'excitation 410 et de détection 420 peuvent être entrelacés.

Le bobinage d'excitation 410 et de détection 420 comportent une pluralité de zones conductrices plates. Certaines zones conductrices plates sont placées dans un premier plan parallèle au plan principal du support par exemple situé au dessous des noyaux 102, 104, tandis que les autres zones conductrices plates sont situées dans un deuxième plan, par exemple parallèle au plan principal du support et au dessus des noyaux 102, 104. Lesdites zones conductrices plates sont parallèles entre elles, et s'étendent respectivement dans une direction réalisant un angle non-nul, par exemple dans une direction orthogonale, avec la direction principale du premier noyau 102 (la direction principale du premier noyau 102 étant une direction parallèle au vecteur *̅i̅*̅ d'un repère orthogonal [O;*̅i̅*̅;*̅j̅*̅;*̅k̅*̅] sur la figure 5A). On entendra par « zone conductrice plate » tout au long de la présente description, un bloc métallique ayant une forme parallélépipédique ou sensiblement parallélépipédique.

Les zones conductrices plates 411, 412, 413, 414, peuvent avoir une largeur lc (mesurée sur la figure 5A dans une direction parallèle au vecteur *̅i̅*̅ du repère orthogonal [O;*̅i̅*̅;*̅j̅*̅;*̅k̅*̅]) supérieure à leur épaisseur e_{c} respective (mesurée sur les figures 5A et 5B dans une direction parallèle au vecteur *̅k̅*̅ du repère orthogonal [O;*̅i̅*̅;*̅j̅*̅;*̅k̅*̅]), par exemple une largeur lc au moins 2 fois supérieure à leur épaisseur e_{c} ou au moins 3 fois supérieure à leur épaisseur e_{c}. Les zones conductrices 411, 412, 413, 414, peuvent avoir une épaisseur e_{c} comprise entre 0,1 µm et 50 µm, ou par exemple comprise entre 1 µm et 5 µm, ou par exemple de l'ordre de 3 µm. Les zones conductrices 411, 412, 413, 414, peuvent également avoir une largeur respective lc comprise entre 1 µm et 50 µm, par exemple de l'ordre de 10 µm, ou par exemple de l'ordre de 3 µm.

Une couche 107 de matériau diélectrique d'épaisseur comprise par exemple entre 0,1 µm et 10 µm, ou par exemple entre 0,1 µm et 3 µm, de préférence inférieure à 1 micromètre, est située entre les noyaux 102 et 104 et lesdites zones conductrices plates 411, 412 placées dans le premier plan. Une autre couche 109 de matériau diélectrique d'épaisseur, comprise par exemple entre 0,1 µm et 10 µm, ou par exemple entre 0,1 µm et 3 µm, de préférence inférieure à 1 micromètre, sépare les noyaux 102 et 104 desdites zones conductrices plates 413, 414 situées dans le deuxième plan.

Le bobinage d'excitation 410 est formé d'une succession d'éléments conducteurs reliés en série le long des noyaux 102 et 104. Les éléments conducteurs du bobinage d'excitation peuvent être respectivement formés : d'une partie conductrice réalisant un contour fermé autour des deux noyaux 102 et 104, d'un premier lien conducteur 418 connecté à ladite partie conductrice et d'un deuxième lien conducteur 419, distinct du premier lien 418 et également connecté à ladite partie conductrice. La partie conductrice réalisant un contour fermé peut être formée d'une première portion conductrice entourant en partie le premier noyau 102 et d'une deuxième portion conductrice entourant en partie le deuxième noyau 104 (figure 5B, le deuxième lien n'étant pas représenté sur cette figure). La première portion conductrice et la deuxième portion conductrice peuvent avoir une forme de U. La première portion conductrice et la deuxième portion conductrice peuvent être identiques.

Le premier lien 418 et le deuxième lien 419 peuvent être orientés dans une direction parallèle à la direction principale donnée des noyaux 102 et 104, et situés respectivement dans le premier plan et dans le deuxième plan. Dans les élément conducteurs du bobinage d'excitation, un desdits premier lien 418 ou deuxième lien 419, est destiné à acheminer un courant I, vers ladite partie conductrice réalisant un contour fermé autour des deux noyaux 102, 104, tandis que l'autre desdits deuxième lien 419 ou premier lien 418, est destiné à acheminer un courant I en provenance de cette partie conductrice réalisant un contour fermé. Dans le cas d'un élément conducteur donné situé à une extrémité du bobinage d'excitation, un desdits premier lien ou deuxième lien de cet élément conducteur donné, est relié à un plot conducteur 230, 232, par lequel un signal d'excitation est destiné à être appliqué, tandis que l'autre desdits premier lien et deuxième lien, est relié à un autre élément conducteur du bobinage d'excitation 410. Pour les autres éléments conducteurs du bobinage d'excitation 410, un desdits premier lien ou deuxième lien, par exemple le premier lien 418 est relié à un élément conducteur précédent de la succession d'élément conducteurs formant le bobinage d'excitation 410, tandis que l'autre desdits premier lien ou deuxième lien, par exemple le deuxième lien 419, est relié à un élément conducteur suivant de la succession d'éléments conducteurs formant le bobinage d'excitation 410. Les éléments conducteurs du bobinage d'excitation sont agencées de sorte qu'un courant I arrivant à un desdits éléments conducteurs, passe par l'un des deux liens 418, 419, relié à ladite partie conductrice formant un contour fermé, par exemple par le premier lien 418, puis se réparti en deux composantes de courant entre les deux portions formant ladite partie conductrice, en sortie de l'élément conducteur, les deux composantes étant regroupées sur l'autre des deux liens, par exemple sur le deuxième lien 419.

Dans ce mode de réalisation, le courant est réparti de manière synchrone entre lesdites deux portions conductrices de la partie conductrice réalisant un contour fermé autour du premier noyau 102 et du deuxième noyau 104. Avec un tel agencement d'éléments conducteurs, les effets parasites qu'une éventuelle imperfection géométrique au niveau d'un élément conducteur pourraient induire, ne se transmettent pas aux éléments conducteurs suivants.

Les éléments conducteurs du bobinage d'excitation 410 peuvent être formés respectivement, notamment, d'une première zone conductrice plate 411 située dans le premier plan en regard du premier noyau 102, et s'étendant dans une direction orthogonale à la direction principale donnée, reliée à une deuxième zone conductrice plate 412 située en regard du deuxième noyau 104 s'étendant dans une direction orthogonale à la direction principale donnée. La deuxième zone conductrice plate 412 est alignée avec la première zone conductrice plate 411 et située dans le prolongement de cette dernière. Les éléments conducteurs du bobinage d'excitation 410 sont formés en outre respectivement : d'une troisième zone conductrice plate 413 située dans le deuxième plan en regard du premier noyau 102, et s'étendant dans une direction orthogonale à la direction principale donnée, ainsi qu'une quatrième zone conductrice plate 414, reliée à la troisième zone conductrice plate 413, la quatrième zone conductrice plate 414 étant située en regard du deuxième noyau 104. La troisième zone conductrice plate 413 est alignée avec la quatrième zone conductrice plate 414 et située dans le prolongement de cette dernière. La première zone conductrice plate 411 et la troisième zone conductrice plate 413 peuvent être superposées. La deuxième conductrice zone plate 412 et la quatrième zone conductrice plate 414 peuvent être également superposées. Une première interconnexion verticale 416 ou premier via 416, orthogonal(e) au plan principal du support, peut être prévue pour relier la première zone conductrice plate 411 à la troisième zone conductrice plate 413. Une deuxième interconnexion 417 verticale ou deuxième via 417, orthogonal(e) au plan principal du substrat relie la deuxième zone conductrice plate 412 à la quatrième zone conductrice plate 414. La première zone conductrice 411 plate, la deuxième conductrice 412, la troisième zone conductrice 413 plate, la quatrième zone conductrice 414 plate, la première interconnexion verticale 416, et la deuxième interconnexion verticale 417, forment ladite partie conductrice réalisant un contour fermé autour des noyaux 102, 104.

Des éléments conducteurs successifs du bobinage d'excitation 410 peuvent être connectées entre eux par l'intermédiaire d'interconnexions verticales 415, reliant un desdits premier lien 418 ou deuxième lien 419 d'un élément conducteur à un autre desdits deuxième lien ou premier lien d'un autre élément conducteur.

Le bobinage de détection 420 est formé quant à lui d'une succession de spires conductrices reliées en série le long des noyaux 102 et 104. Les spires du bobinage de détection 420 peuvent avoir un agencement de type communément appelé « Foster ».

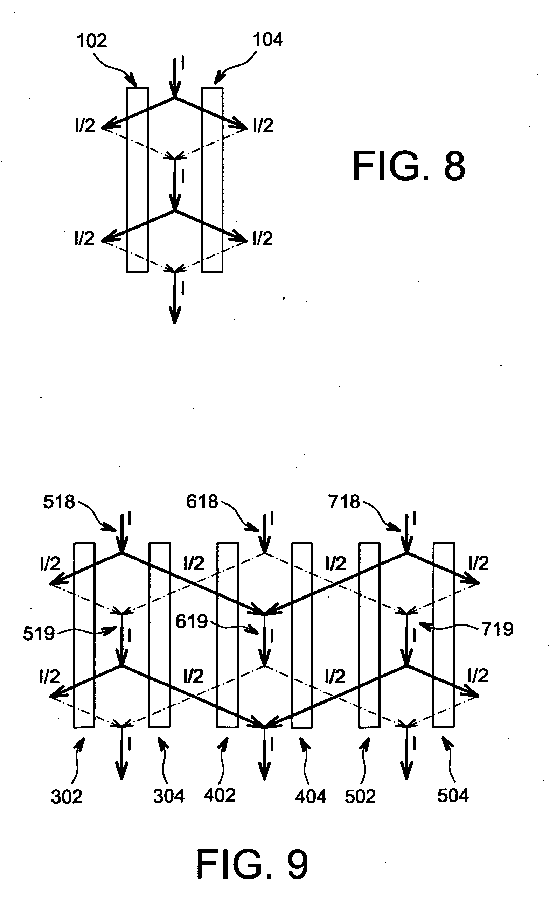

Le bobinage de détection 420 est quant à lui formé d'une succession de spires enroulées autour du premier noyau 102 et du deuxième noyau 104, les spires passant alternativement dans le deuxième plan en regard des noyaux 102, 104, puis dans le premier plan en regard des noyaux 104, 102. Le bobinage de détection 410 est également formé, notamment, de zones conductrices plates 421, 422, distinctes réparties le long des noyaux 102, 104, et situées dans le premier plan, ou dans le deuxième plan. Lesdites zones conductrices plates 421, 422 du bobinage de détection 420 sont parallèles entre elles, et s'étendent respectivement dans une direction réalisant un angle non-nul, par exemple dans une direction orthogonale, avec la direction principale du premier noyau 102. Les zones conductrices plates du bobinage de détection 420 peuvent avoir une largeur respective l'c supérieure, par exemple au moins 2 fois supérieure, à la largeur lc respective des zones conductrices plates du bobinage de détection 420 (les largeurs lc et l'c étant mesurées sur la figure 9A dans une direction parallèle au vecteur *̅i̅*̅ du repère orthogonal [O ;*̅i̅*̅ ; *̅j̅*̅ ; *̅k̅*̅ ] ). La largeur l'c des zones conductrices plates du bobinage de détection 420 peut être par exemple comprise entre 5 µm et 30 µm, tandis que la largeur lc des zones conductrices plates du bobinage de d'excitation 410 peut être par exemple comprise entre 5 µm et 15 µm.

Un bobinage de détection 420 formé de zones conductrices plus larges que celle du bobinage d'excitation 410, peut permettre d'améliorer la sensibilité du magnétomètre et d'homogénéiser le champ de contre réaction, de manière à travailler à champ nul.

Le dispositif comporte également des plots conducteurs 230, 232, 240, 242. Un premier plot conducteur 230 et un deuxième plot conducteur 232 sont reliés respectivement à un premier élément conducteur du bobinage d'excitation 410 situé à une première extrémité des noyaux 102, 104, et à un deuxième élément conducteur du bobinage d'excitation 410 situé à une deuxième extrémité des noyaux 102, 104. Un troisième plot conducteur 240 et un quatrième plot conducteur 242 sont reliés respectivement à une première spire du bobinage de détection 120 située à une première extrémité des noyaux 102, 104 et à une deuxième spire du bobinage de détection 120 située à une deuxième extrémité des noyaux 102, 104.

Avec un dispositif tel que précédemment décrit, on peut annuler le champ d'excitation dans la bobine de détection. Le signal détecté est doublé sans que le bruit soit augmenté proportionnellement. Avec un tel agencement, les sources de bruits ne sont pas corrélées entre les deux noyaux.

Sur la figure 8, un schéma électrique équivalent de l'excitation réalisée autour des deux noyaux 102, 104 est donné.

L'excitation est réalisée de sorte qu'un courant I, circule selon un premier tour autour des noyaux 102, 104, en se subdivisant en 2 contributions I/2 circulant chacune autour d'un des deux noyaux. Puis à la fin de ce premier tour, les deux contributions I/2 sont sommées pour recréer le courant total I qui sera subdivisé à nouveau en 2 contributions I/2 autour de chacun des 2 noyaux, pour effectuer le second tour et à nouveau sommées pour recréer le courant total I et ainsi de suite jusqu'à l'autre extrémité circuit magnétique.

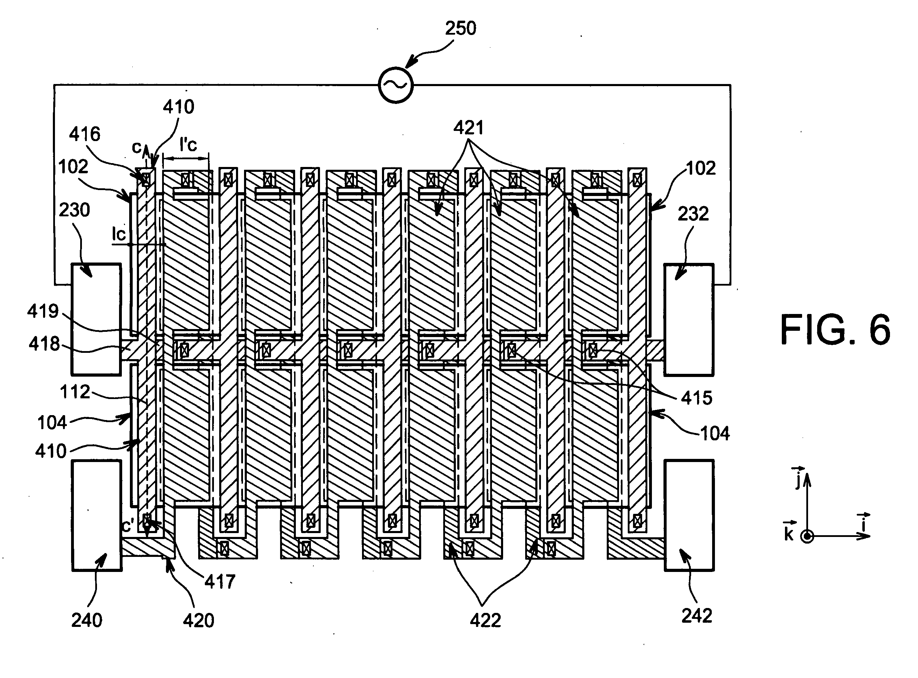

Le premier plot conducteur 230 et le deuxième plot conducteur 232 peuvent être reliés à un générateur 250 de signal d'excitation et prévus pour acheminer le signal d'excitation à destination des noyaux 102 et 104 (figure 6).

Une variante (non représentée) du dispositif qui vient d'être décrit comporte un circuit magnétique fermé. Pour une telle variante, les noyaux 102 et 104 sont reliés par l'intermédiaires de deux zones à base de matériau magnétique formant respectivement un troisième noyau, et un quatrième noyau, le troisième noyau et le quatrième noyau étant accolés respectivement au premier noyau 102 et au deuxième noyau et orientés dans une direction orthogonale à la direction principale du premier noyau 102 et du deuxième noyau 104. Le premier noyau 102, le deuxième noyau 104, le troisième noyau, et le quatrième noyau, réalisent un contour fermé.

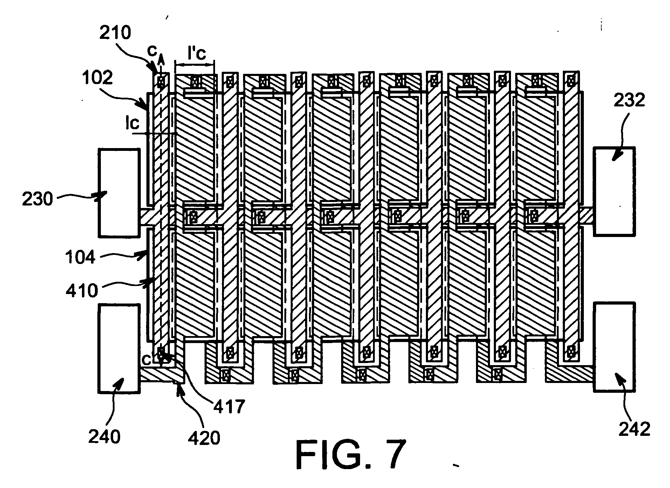

Un dispositif micro-fluxgate biaxe est illustré sur la figure 7.

Ce dispositif comprend un premier micromagnétomètre M1 de type fluxgate tel qu'illustré précédemment en liaison avec la figure 6, comportant un premier circuit magnétique doté du premier noyau 102, du deuxième noyau 104, du bobinage d'excitation 410 et du bobinage de détection 420 décrits précédemment.

Le microfluxgate biaxe comprend en outre un deuxième magnétomètre M2 de type fluxgate, doté d'un deuxième circuit magnétique comprenant deux autres noyaux 102 et 104 juxtaposés, ainsi qu'un autre bobinage d'excitation 410 et un autre bobinage de détection 420. Le deuxième micromagnétomètre M2 a une structure identique à celle du premier micromagnétomètre M1, et est doté de noyaux 102, 104, s'étendant dans une deuxième direction principale donnée à celle des noyaux du premier magnétomètre M1.

Le premier circuit magnétique associé aux bobinages 410, 420 est prévu pour effectuer des mesures de champ magnétique selon ladite première direction principale, tandis que le deuxième circuit magnétique associé aux autres bobinages 410, 420 est prévu pour effectuer des mesures de champ magnétique selon une deuxième direction, orthogonale à ladite première direction principale.

Selon un autre exemple, un micromagnétomètre de type fluxgate suivant l'invention, peut être doté d'un nombre k (avec k un entier supérieur à 2, par exemple égal à 5) noyaux magnétiques parallèles juxtaposés sur un support. Le micromagnétomètre est également doté d'un bobinage d'excitation 410 et d'un bobinage de détection 420 entrelacés.

En mettant en oeuvre un dispositif avec N paires de noyaux plutôt qu'une seule paire on peut augmenter le rapport signal à bruit d'un rapport racine carré de 2*N, le signal détecté étant augmenté dans le rapport 2*N et le bruit dans un rapport racine carré de 2*N.

Typiquement, si on met en oeuvre un dispositif avec 5 paires de noyaux, on peut améliorer le rapport signal à bruit dans un rapport de l'ordre de 3,16 ou √10.

On peut également choisir d'améliorer le rapport signal à bruit sans augmenter le signal en réduisant le nombre de contours conducteurs du bobinage d'excitation par noyau.

Une variante de micromagnétomètre de type fluxgate suivant l'invention, peut être dotée d'un nombre k avec k égal à 6 noyaux 402, 404, 502, 504, 602, 604.

Sur la figure 9, un schéma électrique équivalent de l'excitation d'un tel dispositif réalisée autour des noyaux 302, 304, 402, 404, 502, 504 est donné, les zones conductrices plates du bobinage d'excitation situées en dessous des noyaux étant schématisées par des traits discontinus, tandis que les zones conductrices plates du bobinage d'excitation situées en dessus des noyaux, sont schématisées par des traits pleins.

Dans le cas de k noyaux, on peut agencer le bobinage d'excitation de manière à augmenter la contribution totale du courant de I à k*I, chaque paire de noyaux recevant une contribution de courant I et chaque noyau une contribution de courant I/2. La manière de subdiviser et de sommer les contributions I/2 peut être modifiée par rapport au dispositif de la figure 8.

Les éléments conducteurs du bobinage d'excitation peuvent être respectivement formés : d'une partie conductrice réalisant un contour fermé autour des 6 noyaux 302, 304, 402, 404, 502, 504. Un premier lien 518 situé entre les noyaux 302, 304, un deuxième 618 situé entre les noyaux 402, 404, et un troisième lien 718 situé entre les noyaux 502, 504, sont destinés à acheminer chacun un courant I, vers ladite partie conductrice réalisant un contour fermé autour des 6 noyaux 302, 304, 402, 404, 502, 504. Un quatrième lien 519 situé entre les noyaux 302, 304, un cinquième lien 619 situé entre les noyaux 302, 304, et un sixième 719 situé entre les noyaux 302, 304, sont quant à eux destinés à acheminer un courant I en provenance de cette partie conductrice réalisant un contour fermé.

Les éléments conducteurs du bobinage d'excitation sont agencés de sorte qu'un courant I arrivant au premier lien 518, se divise en deux composantes de courant I/2, une des deux composantes arrivant sur le quatrième lien 519, l'autre des deux composantes arrivant sur le cinquième lien 619 après être passée en regard de deux noyaux voisins 304, 402 consécutifs.

Un courant I arrivant au deuxième lien 618, se divise en deux composantes de courant I/2 une des deux composantes arrivant sur le quatrième lien 519 après être passée en regard de deux noyaux 402, 304 voisins consécutifs, l'autre des deux composantes arrivant sur le septième lien 619, après être passée en regard de deux noyaux 404, 502 voisins consécutifs.

Un courant I arrivant au troisième lien 718, se divise en deux composantes de courant I/2, une des deux composantes arrivant sur le cinquième lien 619 après être passée en regard de deux noyaux consécutifs 502, 404, l'autre des deux composantes arrivant sur le septième lien 719.

Une contribution I/2 effectue la première moitié d'un tour autour d'un noyau et la seconde moitié autour d'un noyau voisin juxtaposé de sorte que à la fin de chaque tour, chaque paire ait bien reçue la contribution totale de I.

## Revendications

1. Micromagnétomètre de type fluxgate réalisé en couches minces, comprenant :
- un support (100-101) ayant un plan principal donné,
- un circuit magnétique doté d'au moins un premier noyau magnétique (102) de direction principale donnée et au moins un deuxième noyau magnétique (104) parallèle au premier noyau,
- au moins un bobinage d'excitation (110,410) formé d'une succession d'éléments conducteurs reliés en série,
- des moyens pour appliquer un signal d'excitation à ladite série d'éléments conducteurs,
le bobinage d'excitation comportant : des zones conductrices plates (411,412,413,414) parallèles entre elles s'étendant dans une direction réalisant un angle non-nul avec ladite direction principale donnée et situées respectivement dans un plan parallèle au plan principal du support, une première pluralité de zones conductrices plates (411,413) étant situées en regard du premier noyau, une deuxième pluralité de zones conductrices plates (412,414) étant situées en regard du deuxième noyau, au moins plusieurs éléments conducteurs du bobinage d'excitation étant formés respectivement : d'au moins une première zone conductrice plate (412) appartenant à ladite deuxième pluralité de zones conductrices reliée à une deuxième zone conductrice plate (411) appartenant à ladite première pluralité de zones conductrices plates et située dans un même plan orthogonal au plan principal du support que ladite deuxième zone conductrice plate, les éléments conducteurs du bobinage d'excitation étant formés respectivement :
- d'une partie conductrice réalisant un contour fermé entourant les noyaux (102,104), et comprenant ladite première zone conductrice plate (411) et ladite deuxième zone conductrice plate (412).

2. Micromagnétomètre de type fluxgate réalisé en couches minces selon la revendication 1, les éléments conducteurs du bobinage d'excitation étant formés respectivement en outre :
- d'un premier lien conducteur (418) relié à ladite partie conductrice et destiné à acheminer un courant en provenance d'un élément conducteur précédent de ladite série d'éléments conducteurs ou des moyens pour appliquer le signal d'excitation,
- d'un deuxième lien conducteur relié à ladite partie conductrice et destiné à transmettre un courant vers un élément conducteur suivant de ladite série d'éléments conducteurs ou aux moyens pour appliquer le signal d'excitation.

3. Micromagnétomètre de type fluxgate réalisé en couches minces selon la revendication 1 ou 2, lesdites zones conductrices plates de ladite première pluralité de zones conductrices plates et de ladite deuxième pluralité de zones conductrices plates, étant orientées selon une direction orthogonale à ladite direction principale donnée.

4. Micromagnétomètre de type fluxgate réalisé en couches minces selon l'une des revendication 1 à 3, dans lequel ladite première zone conductrice plate (411) et ladite deuxième zone conductrice plate (412) sont situées dans un premier plan parallèle au plan principal du support, ladite deuxième zone conductrice plate étant reliée et alignée avec ladite première zone conductrice plate.

5. Micromagnétomètre de type fluxgate réalisé en couches minces selon l'une des revendication 1 à 4, ledit contour conducteur fermé comprenant en outre : une troisième zone conductrice plate (413) et une quatrième zone conductrice plate (414) reliée à, et alignée avec, la troisième zone conductrice plate, la troisième zone conductrice plate et la quatrième zone conductrice plate étant connectées respectivement à ladite première zone conductrice plate (411) et à ladite deuxième zone conductrice plate (414) et étant situées dans un deuxième plan, parallèle au plan principal du support et tel que les noyaux sont placés entre ledit premier plan et ledit deuxième plan.

6. Micromagnétomètre de type fluxgate réalisé en couches minces selon la revendication 5, lesdites troisième zone conductrice plate (413) et quatrième zone conductrice plate (414) étant situées dans un même plan orthogonal au plan principal du support que les dites première zone conductrice plate (411) et deuxième zone conductrice plate (412).

7. Micromagnétomètre de type fluxgate réalisé en couches minces selon l'une des revendications 1 à 6, ladite partie conductrice réalisant un contour fermé étant formé d'une première portion conductrice entourant partiellement le premier noyau et d'une deuxième portion conductrice entourant partiellement le deuxième noyau, la première portion conductrice et la deuxième portion conductrice étant identiques.

8. Micromagnétomètre de type fluxgate réalisé en couches minces selon l'une des revendications 1 à 7, dans lequel le premier lien conducteur (418) et le deuxième lien conducteur (419) sont situés entre les noyaux (102,104) et orientés dans une direction parallèle à la direction principale donnée, le deuxième lien et le premier lien étant situés respectivement dans un premier plan parallèle au plan principal du support, et dans un deuxième plan, parallèle au plan principal du support et tel que les noyaux sont placés entre le premier plan et le deuxième plan.

9. Micromagnétomètre de type fluxgate réalisé en couches minces selon l'une des revendications 1 à 8, dans lequel le circuit magnétique comprend en outre un ou plusieurs autres noyaux juxtaposés parallèles entre eux et au premier et deuxième noyaux, plusieurs éléments conducteurs du bobinage d'excitation étant formés en outre respectivement : d'une pluralité de zones conductrices plates s'étendant dans une direction réalisant un angle non-nul avec ladite direction principale donnée et situées dans un même plan orthogonal au plan principal du support que lesdites première zone conductrice plate et deuxième zone conductrice plate.

10. Micromagnétomètre de type fluxgate réalisé en couches minces selon l'une des revendications 1 à 9, dans lequel le circuit magnétique comprend en outre un ou plusieurs autres noyaux juxtaposés parallèles entre eux et au premier et deuxième noyaux, ladite partie conductrice entourant également lesdits autres noyaux.

11. Micromagnétomètre de type fluxgate réalisé en couches minces selon l'une des revendications 1 à 10, comprenant en outre au moins un bobinage de détection (420) enroulé autour des noyaux (102,104,).

12. Micromagnétomètre de type fluxgate réalisé en couches minces selon la revendication 11, le bobinage de détection (120,520) et le bobinage de d'excitation (110,510) étant entrelacés.

13. Micromagnétomètre de type fluxgate réalisé en couches minces selon la revendication 11 ou 12, le bobinage de détection étant formé d'une succession de spires passant respectivement alternativement, en regard de tous les noyaux (102,104) dans un premier plan parallèle au plan principal du support et en regard de tous les noyaux (102,104) dans un deuxième plan parallèle au plan principal du support et tel que les noyaux sont situés entre le premier plan et le deuxième plan.

14. Micromagnétomètre de type fluxgate réalisé en couches minces selon l'une des revendications 11 à 13, dans lequel le bobinage de détection est formé d'une succession de spires conductrices reliés en série, un pluralité de spires du bobinage de détection comportant respectivement : une pluralité de zones conductrices plates parallèles entre elles, situées respectivement en regard des noyaux du circuit magnétique dans un plan parallèle au plan principal du support et s'étendant respectivement dans une direction réalisant un angle non-nul avec ladite direction principale donnée, les zones conductrices plates du bobinage de détection (420) ayant une largeur (1'c) supérieure à la largeur (1c) des zones conductrices plates du bobinage d'excitation (410).

15. Dispositif réalisé en couches minces comprenant :
- un premier micromagnétomètre de type fluxgate selon l'une des revendications 1 à 14, doté de noyaux orientés selon une première direction principale,
- aux moins un deuxième micromagnétomètre de type fluxgate selon l'une des revendications 1 à 14, doté de noyaux orientés selon une deuxième direction principale orthogonale à ladite première direction principale.

## Patentansprüche

1. Fluxgate-Mikromagnetometer, das in dünnen Schichten ausgebildet ist, enthaltend:
- einen Träger (100 - 101) mit einer gegebenen Hauptebene,
- einen magnetischen Kreis, der mit zumindest einem ersten Magnetkern (102) mit einer gegebenen Hauptrichtung und zumindest einem zweiten Magnetkern (104) versehen ist, der parallel zum ersten Kern verläuft,
- zumindest eine Erregerwicklung (110, 410), die aus einer Folge von in Reihe verbundenen leitfähigen Elementen gebildet ist,
- Mittel zum Anlegen eines Erregersignals an die Reihe von leitfähigen Elementen,
wobei die Erregerwicklung aufweist: leitfähige, flache Bereiche (411, 412, 413, 414), die parallel zueinander verlaufen und sich in einer Richtung erstrecken, die einen Winkel ungleich null mit der gegebenen Hauptrichtung einschließt, und jeweils in einer Ebene parallel zur Hauptebene des Trägers liegen, wobei eine erste Mehrzahl von leitfähigen flachen Bereichen (411, 413) dem ersten Kern gegenüberliegt, wobei eine zweite Mehrzahl von leitfähigen flachen Bereichen (412, 414) dem zweiten Kern gegenüber liegt, wobei zumindest mehrere leitfähige Elemente der Erregerwicklung jeweils gebildet sind aus: zumindest einem ersten leitfähigen flachen Bereich (412), der zur zweiten Mehrzahl von leitfähigen Bereichen gehört und mit einem zweiten leitfähigen flachen Bereich (411) verbunden ist, der zur ersten Mehrzahl von leitfähigen flachen Bereichen gehört und in einer gleichen orthogonal zur Hauptebene des Trägers verlaufenden Ebene wie der zweite leitfähige flache Bereich liegt, wobei die leitfähigen Elemente der Erregerwicklung jeweils gebildet sind aus:
- einem leitfähigen Teil, der eine die Kerne (102, 104) umgebende geschlossene Kontur bildet und den ersten leitfähigen flachen Bereich (411) und den zweiten leitfähigen flachen Bereich (412) aufweist.

2. Fluxgate-Mikromagnetometer, das in dünnen Schichten ausgebildet ist, nach Anspruch 1, wobei die leitfähigen Elemente der Erregerwicklung ferner jeweils ausgebildet sind aus:
- einem ersten leitfähigen Bindeglied (418), das mit dem leitfähigen Teil verbunden und dazu bestimmt ist, einen Strom weiterzuleiten, der von einem vorherigen leitfähigen Element der Reihe von leitfähigen Elementen oder von den Mitteln zum Anlegen des Erregersignals stammt,
- einem zweiten leitfähigen Bindeglied, das mit dem leitfähigen Teil verbunden und dazu bestimmt ist, einen Strom zu einem nachfolgenden leitfähigen Element der Reihe von leitfähigen Elementen oder zu den Mitteln zum Anlegen des Erregersignals zu übertragen.

3. Fluxgate-Mikromagnetometer, das in dünnen Schichten ausgebildet ist, nach Anspruch 1 oder 2, wobei die leitfähigen flachen Bereiche der ersten Mehrzahl von leitfähigen flachen Bereichen und der zweiten Mehrzahl von leitfähigen flachen Bereichen in einer Richtung orthogonal zur gegebenen Hauptrichtung ausgerichtet sind.

4. Fluxgate-Mikromagnetometer, das in dünnen Schichten ausgebildet ist, nach einem der Ansprüche 1 bis 3, wobei der erste leitfähige flache Bereich (411) und der zweite leitfähige flache Bereich (412) in einer ersten Ebene parallel zur Hauptebene des Trägers liegen, wobei der zweite leitfähige flache Bereich mit dem ersten leitfähigen flachen Bereich verbunden ist und mit diesem fluchtet.

5. Fluxgate-Mikromagnetometer, das in dünnen Schichten ausgebildet ist, nach einem der Ansprüche 1 bis 4, wobei die leitfähige geschlossene Kontur ferner aufweist: einen dritten leitfähigen flachen Bereich (413) und einen vierten leitfähigen flachen Bereich (414), der mit dem dritten leitfähigen flachten Bereich verbunden ist und mit diesem fluchtet, wobei der dritte leitfähige flache Bereich und der vierte leitfähige flache Bereich an den ersten leitfähigen flachen Bereich (411) bzw. an den zweiten leitfähigen flachen Bereich (414) angeschlossen sind und in einer zweiten Ebene liegen, die parallel zur Hauptebene des Trägers verläuft, derart, dass die Kerne zwischen der ersten Ebene und der zweiten Ebene angeordnet sind.

6. Fluxgate-Mikromagnetometer, das in dünnen Schichten ausgebildet ist, nach Anspruch 5, wobei der dritte leitfähige flache Bereich (413) und der vierte leitfähige flache Bereich (414) in einer gleichen Ebene orthogonal zur Hauptebene des Trägers wie der erste leitfähige flache Bereich (411) und der zweite leitfähige flache Bereich (412) liegen.

7. Fluxgate-Mikromagnetometer, das in dünnen Schichten ausgebildet ist, nach einem der Ansprüche 1 bis 6, wobei der eine geschlossene Kontur bildende leitfähige Teil aus einem ersten leitfähigen Abschnitt, der den ersten Kern teilweise umgibt, und aus einem zweiten leitfähigen Abschnitt gebildet ist, der den zweiten Kern teilweise umgibt, wobei der erste leitfähige Abschnitt und der zweite leitfähige Abschnitt identisch sind.

8. Fluxgate-Mikromagnetometer, das in dünnen Schichten ausgebildet ist, nach einem der Ansprüche 1 bis 7, wobei das erste leitfähige Bindeglied (418) und das zweite leitfähige Bindeglied (419) zwischen den Kernen (102, 104) liegen und in einer Richtung parallel zur gegebenen Hauptrichtung ausgerichtet sind, wobei das zweite Bindeglied und das erste Bindeglied in einer ersten Ebene parallel zur Hauptebene des Trägers bzw. in einer zweiten Ebene parallel zur Hauptebene des Trägers liegen, derart, dass die Kerne zwischen der ersten Ebene und der zweiten Ebene angeordnet sind.

9. Fluxgate-Mikromagnetometer, das in dünnen Schichten ausgebildet ist, nach einem der Ansprüche 1 bis 8, wobei der magnetische Kreis ferner einen oder mehrere weitere nebeneinanderliegende Kerne aufweist, die parallel zueinander und zum ersten und zum zweiten Kern verlaufen, wobei mehrere leitfähige Elemente der Erregerwicklung ferner ausgebildet sind aus: einer Mehrzahl von leitfähigen flachen Bereichen, die sich in einer Richtung erstrecken, die einen Winkel ungleich null mit der gegebenen Hauptrichtung einschließt, und in einer gleichen Ebene orthogonal zur Hauptebene des Trägers wie der erste leitfähige flache Bereich und der zweite leitfähige flache Bereich liegen.

10. Fluxgate-Mikromagnetometer, das in dünnen Schichten ausgebildet ist, nach einem der Ansprüche 1 bis 9, wobei der magnetische Kreis ferner einen oder mehrere weitere nebeneinanderliegende Kerne aufweist, die parallel zueinander und zum ersten und zum zweiten Kern verlaufen, wobei der leitfähige Teil auch die weiteren Kerne umgibt.

11. Fluxgate-Mikromagnetometer, das in dünnen Schichten ausgebildet ist, nach einem der Ansprüche 1 bis 10, ferner enthaltend zumindest eine Erfassungswicklung (420), die um die Kerne (102, 104) gewickelt ist.

12. Fluxgate-Mikromagnetometer, das in dünnen Schichten ausgebildet ist, nach Anspruch 11, wobei die Erfassungswicklung (120, 520) und die Erregerwicklung (110, 510) verflochten sind.

13. Fluxgate-Mikromagnetometer, das in dünnen Schichten ausgebildet ist, nach Anspruch 11 oder 12, wobei die Erfassungswicklung aus einer Folge von Windungen gebildet ist, die jeweils abwechselnd an allen Kernen (102, 104) in einer ersten Ebene parallel zur Hauptebene des Trägers vorbei bzw. an allen Kernen (102, 104) in einer zweiten Ebene parallel zur Hauptebene des Trägers vorbei verlaufen, derart, dass die Kerne zwischen der ersten Ebene und der zweiten Ebene liegen.

14. Fluxgate-Mikromagnetometer, das in dünnen Schichten ausgebildet ist, nach einem der Ansprüche 11 bis 13, wobei die Erfassungswicklung aus einer Folge von in Reihe verbundenen leitfähigen Windungen gebildet ist, wobei eine Mehrzahl von Windungen der Erfassungswicklung jeweils enthält: eine Mehrzahl von leitfähigen flachen Bereichen, die parallel zueinander verlaufen und jeweils gegenüber den Kernen des magnetischen Kreises in einer Ebene parallel zur Hauptebene des Trägers liegen und sich jeweils in einer Richtung erstrecken, die einen Winkel ungleich null mit der gegebenen Hauptrichtung einschließt, wobei die leitfähigen flachen Bereiche der Erfassungswicklung (420) eine Breite (1'c) haben, die größer ist als die Breite (1 c) der leitfähigen flachen Bereiche der Erregerwicklung (410).

15. Vorrichtung, ausgebildet in dünnen Schichten, enthaltend:
- ein erstes Fluxgate-Mikromagnetometer nach einem der Ansprüche 1 bis 14, ausgestattet mit Kernen, die in einer ersten Hauptrichtung ausgerichtet sind,
- zumindest ein zweites Fluxgate-Mikromagnetometer nach einem der Ansprüche 1 bis 14, ausgestattet mit Kernen, die in einer zweiten Hauptrichtung orthogonal zur ersten Hauptrichtung ausgerichtet sind.

## Claims

1. Micromagnetometer of the fluxgate type implemented in thin layers, including:
- a support (100-101) having a given main plane,
- a magnetic circuit fitted with at least one first magnetic core (102) of given main direction and at least one second magnetic core (104) parallel to the first core,
- at least one excitation coil (110, 410) formed of a succession of conductive elements connected in series,
- means for applying an excitation signal to said series of conductive elements,
the excitation coil comprising: flat conductive zones (411, 412, 413, 414) parallel to each other extending in a direction that forms a non-zero angle with said given main direction and located respectively in a plane parallel to the main plane of the support, a first plurality of flat conductive zones (411, 413) being located opposite the first core, a second plurality of flat conductive zones (412, 414) being located opposite the second core, at least several conductive elements of the excitation coil being formed respectively: of at least one first flat conductive zone (411) belonging to said second plurality of conductive zones connected to a second flat conductive zone (412) belonging to said first plurality of flat conductive zones and located in the same plane orthogonal to the main plane of the support as said second flat conductive zone, the conductive elements of the excitation coil being formed respectively:
- of a conductive part implementing a closed contour surrounding the cores (102, 104), and including said first flat conductive zone (411) and said second flat conductive zone (412).

2. Micromagnetometer of the fluxgate type implemented in thin layers according to claim 1, the conductive elements of the excitation coil being formed moreover respectively:
- of a first conductive link (418) connected to said conductive part and intended to route a current coming from a previous conductive element of said series of conductive elements or means for applying the excitation signal,
- of a second conductive link connected to said conductive part and intended to transmit a current to a next conductive element of said series of conductive elements or to the means for applying the excitation signal.

3. Micromagnetometer of the fluxgate type implemented in thin layers according to any of the claims 1 or 2, said flat conductive zones of said first plurality of flat conductive zones, and of said second plurality of flat conductive zones, being orientated along a direction orthogonal to said given main direction.

4. Micromagnetometer of the fluxgate type implemented in thin layers according to any of the claims 1 to 3, wherein said first flat conductive zone (411) and said second flat conductive zone (412) are located in a first plane parallel to the main plane of the support, said second flat conductive zone being connected and aligned with said first flat conductive zone.

5. Micromagnetometer of the fluxgate type implemented in thin layers according to any of the claims 1 to 4, said closed conductive contour additionally including: a third flat conductive zone (413) and a fourth flat conductive zone (414) connected to, and aligned with, the third flat conductive zone, the third flat conductive zone and the fourth flat conductive zone being connected respectively to said first flat conductive zone (411) and to said second flat conductive zone (414) and being located in a second plane, parallel to the main plane of the support and such that the cores are placed between said first plane and said second plane.

6. Micromagnetometer of the fluxgate type implemented in thin layers according to claim 5, said third flat conductive zone (413) and fourth flat conductive zone (414) being located in the same plane orthogonal to the main plane of the support as said first flat conductive zone (411) and second flat conductive zone (412).

7. Micromagnetometer of the fluxgate type implemented in thin layers according to any of the claims 1 to 6, said conductive part implementing a closed contour being formed of a first conductive portion partially surrounding the first core and a second conductive portion partially surrounding the second core, the first conductive portion and the second conductive portion being identical.

8. Micromagnetometer of the fluxgate type implemented in thin layers according to any of the claims 1 to 7, wherein the first conductive link (418) and the second conductive link (419) are located between the cores (102, 104) and orientated in a direction parallel to the given main direction, the second link and the first link being located respectively in a first plane parallel to the main plane of the support, and in a second plane, parallel to the main plane of the support and such that the cores are placed between the first plane and the second plane.

9. Micromagnetometer of the fluxgate type implemented in thin layers according to any of the claims 1 to 8, wherein the magnetic circuit additionally includes one or more other juxtaposed cores parallel to each other and to the first and second cores, several conductive elements of the excitation coil being formed moreover respectively: of a plurality of flat conductive zones extending in a direction forming a non-zero angle with said given main direction and located in the same plane orthogonal to the main plane of the support as said first flat conductive zone and second flat conductive zone.

10. Micromagnetometer of the fluxgate type implemented in thin layers according to any of the claims 1 to 9, wherein the magnetic circuit additionally includes one or more other juxtaposed cores parallel to each other and to the first and second cores, said conductive part also surrounding said other cores.

11. Micromagnetometer of the fluxgate type implemented in thin layers according to any of the claims 1 to 10, additionally including at least one detection coil (420) wound around the cores (102, 104).

12. Micromagnetometer of the fluxgate type implemented in thin layers according to claim 11, the detection coil (120, 520) and the excitation coil (110, 510) being interlaced.

13. Micromagnetometer of the fluxgate type implemented in thin layers according to claim 11 or 12, the detection coil being formed of a succession of turns passing respectively alternately, opposite all the cores (102, 104) in a first plane parallel to the main plane of the support and opposite all the cores (102, 104) in a second plane parallel to the main plane of the support and such that the cores are located between the first plane and the second plane.

14. Micromagnetometer of the fluxgate type implemented in thin layers according to one of claims 11 to 13, wherein the detection coil is formed of a succession of conductive turns connected in series, a plurality of turns of the detection coil comprising respectively: a plurality of flat conductive zones parallel to each other, located respectively opposite the cores of the magnetic circuit in a plane parallel to the main plane of the support and extending respectively in a direction forming a non-zero angle with said given main direction, the flat conductive zones of the detection coil (420) having a width (1'c) larger than the width (1c) of the flat conductive zones of the excitation coil (410).

15. Device implemented in thin layers that includes:
- a first micromagnetometer of the fluxgate type according to any of the claims 1 to 14, fitted with cores orientated along a first main direction,
- at least one second micromagnetometer of the fluxgate type according to one of claims 1 to 14, fitted with cores orientated along a second main direction orthogonal to said first main direction.
